# FASCICULE DE BREVET EUROPEEN

(11) **EP 1 591 558 B1**
(45) Date de publication et mention de la délivrance du brevet: **11.07.2007**
(21) Numéro de dépôt: 05354017.5
(22) Date de dépôt: 08.04.2005
(51) Int. Cl.: C23C 16/40, C23C 16/56

(54) **Procédé de dépôt d'une couche mince sur une couche oxydée d'un substrat**
Verfahren zur Abscheidung einer Dünnschicht auf einer oxidierten Oberflächenschicht eines Substrats
Process to deposit a thin layer on an oxidized substrate layer

(30) Priorité: 27.04.2004 FR 0404461
(43) Date de publication de la demande: 02.11.2005
(73) Titulaire: COMMISSARIAT A L'ENERGIE ATOMIQUE, 75752 Paris (FR)
(72) Inventeur: Damlencourt, Jean-François, 38120 Saint-Egrève (FR); Renault, Olivier, 38660 Saint-Pancrasse (FR)
(74) Mandataire: Jouvray, Marie-Andrée

(56) Documents cités:
- US-A1- 2002 190 294
- US-A1- 2004 023 461
- US-A1- 2004 025 787
- US-A1- 2004 043 630
- KAWAHARA T ET AL: "EFFECT OF PURGE TIME ON THE PROPERTIES OF HFO2 FILMS PREPARED BY ATOMIC LAYER DEPOSITION" IEICE TRANSACTIONS ON ELECTRONICS, INSTITUTE OF ELECTRONICS INFORMATION AND COMM. ENG. TOKYO, JP, vol. E87-C, no. 1, janvier 2004 (2004-01), pages 2-8, XP001185935 ISSN: 0916-8524

## Description

### Domaine technique de l'invention

L'invention concerne un procédé de dépôt d'une couche mince comprenant au moins un métal et un élément chimique non métallique sur une couche oxydée d'un substrat disposé dans un réacteur, la couche mince étant constituée par une pluralité de couches atomiques superposées, formées par répétition d'un cycle de réaction comprenant au moins les étapes successives suivantes :
- une première étape d'injection dans le réacteur d'un premier réactif métallique halogéné,
- une première étape de purge du réacteur,
- une seconde étape d'injection dans le réacteur d'un second réactif comportant l'élément chimique non métallique,
- une seconde étape de purge du réacteur.

### État de la technique

Pour obtenir des micro-dispositifs performants, rapides et à faible consommation, il est, de plus en plus, nécessaire d'intégrer un maximum de micro-composants, tels que des transistors à effet de champ par exemple de type MOS, sur une même puce électronique. Cependant, pour conserver un couplage capacitif le plus élevé possible, la réduction des dimensions surfaciques de chaque micro-composant entraîne obligatoirement une diminution de l'épaisseur de l'oxyde de grille disposé sur le substrat.

L'oxyde de grille le plus utilisé dans le domaine de la micro-électronique est l'oxyde de silicium, formé par oxydation du substrat en silicium. Il présente, en effet, l'avantage d'être parfaitement compatible avec le substrat et d'être une interface adaptée, du point de vue physique, chimique et électrique, aux micro-composants destinés à être intégrés sur le substrat. Or, la nécessité de réduire l'épaisseur de l'oxyde de grille n'est pas compatible avec l'utilisation de l'oxyde de silicium en tant qu'isolant. Les courants de fuite obtenus dans un oxyde de grille ayant une épaisseur inférieure à 1,5 nm, sont trop élevés.

Pour remédier à ces inconvénients, il a été proposé de remplacer l'oxyde de silicium par des matériaux ayant une constante diélectrique K plus élevée et appelés matériaux à constante diélectrique élevée ou matériaux "High K".

En effet, si pour réaliser un transistor permettant un couplage capacitif C, l'oxyde de grille en oxyde de silicium doit avoir une épaisseur prédéterminée, en remplaçant l'oxyde de silicium par un matériau "High K" présentant une constante diélectrique k₂ supérieure à celle de l'oxyde de silicium (k₁ = 3,9), l'épaisseur e de l'oxyde de grille peut être augmentée d'un facteur (k₂/k₁). L'épaisseur e de la couche est également appelée épaisseur physique tandis que l'épaisseur d'équivalence d'oxyde EOT peut être appelée épaisseur électrique et elle correspond à la formule suivante: EOT = (k₁ / kᵢ)×eᵢ, où kᵢ et eᵢ sont respectivement la constante diélectrique et l'épaisseur physique d'une couche d'oxyde de nature i et où k, correspond à la constante diélectrique de l'oxyde de silicium.

Ainsi, l'EOT est une valeur permettant de comparer, pour un couplage capacitif équivalent, les épaisseurs physiques de l'oxyde de silicium et d'un oxyde de nature différente, c'est-à-dire ayant une constante diélectrique différente de celle de l'oxyde de silicium. Cette valeur permet également de comparer, à épaisseur physique identique, le couplage capacitif de deux condensateurs de surface identique, respectivement avec l'oxyde de silicium et un oxyde de nature différente comme isolant de grille. Le remplacement de l'oxyde de silicium par un matériau "High K" permet donc de réaliser un oxyde de grille de plus grande épaisseur tout en conservant une même valeur d'épaisseur d'équivalence d'oxyde aussi appelée "EOT".

L'intégration d'un matériau "High K" doit, cependant, être adaptée au procédé de fabrication des transistors à effet de champ utilisant l'oxyde de silicium comme oxyde de grille. Ainsi, le matériau "High K" doit être parfaitement compatible avec le substrat, généralement en silicium, et il doit être, plus particulièrement, stable thermodynamiquement et thermiquement.

G.D. Wilk et al. dans l'article " High-K gate dielectrics : Current status and matérials properties considerations" (Journal of applied physics, Vol 89, n° 10, 15 Mai 2001, pages 5243 à 5275) ont étudié les différents matériaux "High K" susceptibles de remplacer l'oxyde de silicium. Ils proposent d'utiliser des oxydes métalliques du groupe IVB, tels que TiO_{2,}, ZrO₂ et HfO₂, à la place de l'oxyde de silicium.

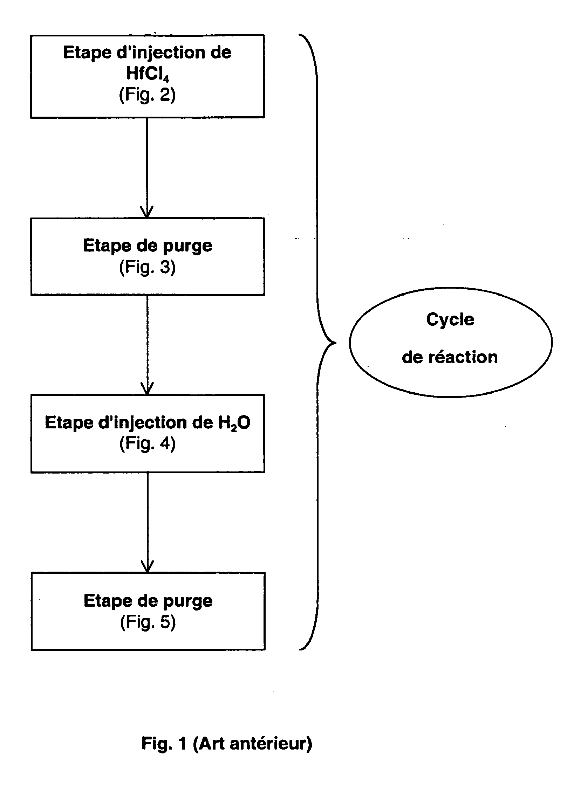

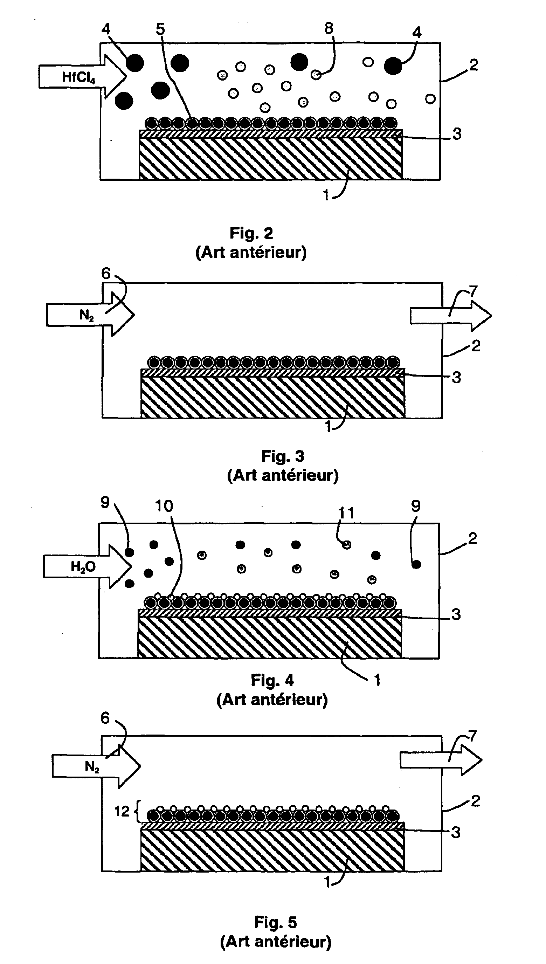

De tels oxydes métalliques sont avantageusement déposés sur un substrat sensible à l'oxydation comme le silicium ou le germanium, par un procédé de dépôt de type "ALD" ("Atomic Layer Deposition" ou dépôt par couche atomique). En effet, le procédé de dépôt de type "ALD" consiste à réaliser des dépôts successifs de couches atomiques, à basse température, ce qui permet de limiter les éventuelles réactions entre l'oxyde métallique et le substrat. Ainsi, comme illustré à la figure 1, le dépôt de type "ALD" d'une couche mince en oxyde d'hafnium, HfO₂, sur un substrat en silicium est réalisé par répétition d'un cycle de réaction. Le cycle de réaction comprend successivement une étape d'injection dans le réacteur d'un précurseur métallique halogéné, par exemple HfCl₄, d'une première étape de purge du réacteur, d'une étape d'injection d'eau dans le réacteur et enfin d'une seconde étape de purge du réacteur (figure 4). Le cycle de réaction est généralement répété jusqu'à l'obtention d'une couche mince en HfO₂ d'une épaisseur prédéterminée puis la couche mince subit le plus souvent un recuit destiné à stabiliser thermodynamiquement la couche mince.

Le procédé de dépôt de type "ALD" implique, cependant, que la surface du substrat comporte des sites de nucléation favorisant l'adsorption de précurseur métallique. Ces sites de nucléation sont, dans le cas de dépôt d'oxyde en matériau "High K", des groupements hydroxydes "-OH" et ils sont, en pratique, obtenus par l'intermédiaire d'une couche interfaciale oxydée comprenant une ou plusieurs monocouches.

Or, l'utilisation de réactifs chlorés lors des cycles de réaction et la nécessité de réaliser un recuit après dépôt entraînent une croissance de la couche interfaciale oxydée comme indiqué dans l'article "Thermal stability and structural characteristics of HfO2 films on Si(100) grown by atomic-layer deposition" de M.-H.Cho et al (Applied Physics Letters, Vol. 81, N°3, pages 472 à 474, 15/07/2002). Or, le phénomène de croissance de la couche interfaciale, aussi appelé phénomène de re-croissance de la couche interfaciale, fait perdre le bénéfice apporté par l'utilisation du matériau "High K".

J.F Damlencourt et al., dans l'article "Electrical and physico-chemical characterization of HfO2/SiO2 gate oxyde stacks prepared by atomic layer deposition" (Solide-State Electronics, 47 (2003), 1613-1616), ont étudié le phénomène de croissance de la couche interfaciale à la suite d'un recuit après dépôt. Ils indiquent que la croissance de la couche interfaciale peut être limitée en contrôlant certains paramètres de l'étape de recuit, notamment en réalisant le recuit à haute température et sous azote. Ils mentionnent également le fait qu'en réalisant des étapes d'injection d'eau plus courtes, lors de chaque cycle de réaction du procédé de dépôt, il est possible de réduire l'épaisseur de la couche interfaciale et d'améliorer la valeur de l'EOT des couches en HfO₂, après recuit. Ces moyens ne sont, cependant, pas suffisants pour contrôler de manière satisfaisante, le phénomène de re-croissance de la couche interfaciale.

Le document US2004/023461 décrit la formation d'un film diélectrique en HfO₂/ZrO₂, par procédé de dépôt de type « ALD ». Une couche en HfO₂ est formée, en utilisant Hfl₄ comme précurseur, puis une couche en ZrO₂ est déposée sur la couche en HfO₂. L'épaisseur de la couche en HfO₂ est contrôlée par la répétition de cycles comprenant les étapes classiques suivantes : injection du précurseur Hfl₄ dans une chambre de réaction, purge, injection d'un précurseur contenant l'oxygène et purge.

L'article « Effect of purge time on the properties of HfO2 films prepared by atomic layer deposition » de Takaaki Kawahara (IEICE Trans. Elctron., Vol.E87-C, N°1, Janvier 2004) étudie, par ailleurs, l'effet des temps de purge sur les propriétés des films en HfO₂ déposés par dépôt de type « ALD », en utilisant HfCl₄ et H₂O comme précurseurs. L'article précise que pour éliminer totalement l'excès de précurseurs et de sous-produits, une longue période de purge est nécessaire après l'étape d'injection d'H₂O. Plus particulièrement, la durée de ladite étape de purge est plus de 30 fois supérieure à celle de l'étape de purge réalisée après l'injection de HfCl₄

### Objet de l'invention

L'invention a pour but de réaliser un procédé de dépôt d'une couche mince sur une couche oxydée d'un substrat, par dépôt de type "ALD" et permettant de contrôler de manière efficace le phénomène de croissance de la couche interfaciale oxydée.

Selon l'invention, ce but est atteint par les revendications annexées. Plus particulièrement, ce but est atteint par le fait que le procédé de dépôt comporte, après chaque dépôt d'une couche atomique, au moins une séquence de densification comportant une troisième étape de purge, une étape d'injection supplémentaire du second réactif et une quatrième étape de purge.

Selon un développement de l'invention, la durée d'une séquence de densification est largement supérieure à la durée d'un cycle de réaction.

Selon un autre développement de l'invention, les durées de chaque étape de purge et de l'étape d'injection supplémentaire d'une séquence sont largement supérieures aux durées respectives de chaque étape de purge et de la seconde étape d'injection d'un cycle de réaction.

Selon un mode de réalisation préférentiel, la durée de l'étape d'injection supplémentaire est comprise entre 300 millisecondes et 1000 millisecondes secondes tandis que la durée de la seconde étape d'injection est comprise entre 50 millisecondes et 100 millisecondes.

Selon une autre caractéristique de l'invention, la durée des troisième et quatrième étapes de purge est de l'ordre de quelques secondes tandis que la durée des première et seconde étapes de purge est de l'ordre de quelques centaines de millisecondes.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente schématiquement les différentes étapes d'un cycle de réaction selon l'art antérieur.
Les figures 2 à 5 sont des représentations schématiques en coupe d'un réacteur, respectivement lors d'une étape d'injection d'HfCl₄, lors d'une étape de purge, lors d'une étape d'injection d'H₂O et lors d'une étape de purge d'un cycle de réaction selon l'art antérieur.
Les figures 6 et 7 représentent schématiquement et respectivement les différentes étapes d'un dépôt d'une couche atomique en HfO₂ selon l'art antérieur et d'une couche mince en HfO₂ selon l'invention.
La figure 8 représente schématiquement les différentes étapes d'une séquence de densification de la couche atomique en HfO₂ déposée selon la figure 7.
La figure 9 représente un spectre de niveau de coeur Si 2p obtenu par spectroscopie de photoélectrons par rayons X (XPS) d'un substrat en silicium sur lequel est déposée une couche d'oxyde de silicium de 0,7nm d'épaisseur.
Les figures 10 et 11 représentent chacune un spectre de niveau de coeur Si 2p obtenu par XPS d'un substrat en silicium selon la figure 9 et sur lequel est déposée une couche mince d'HfO₂ selon l'art antérieur, respectivement avant et après un recuit.
Les figures 12 et 13 représentent chacune un spectre de niveau de coeur Si 2p obtenu par XPS d'un substrat en silicium selon la figure 9 et sur lequel est déposée d'HfO₂ selon l'invention, respectivement avant et après un recuit.
Les figures 14 et 15 représentent chacune la variation de l'EOT en fonction de l'épaisseur d'une couche d'HfO₂ déposée respectivement selon l'art antérieur et selon l'invention.
La figure 16 représente la variation de la capacité en fonction de la tension d'un composant de type capacitif élaboré sur un substrat comportant une couche en HfO₂ selon l'art antérieur et selon l'invention, pour une même valeur d'EOT.
La figure 17 représente la densité d'états d'interface en fonction de (Ef-Ei) selon la figure 16.

### Description de modes particuliers de réalisation

Un procédé de dépôt par couche atomique, également appelé procédé de dépôt de type "ALD", permet de déposer, dans un réacteur étanche et sur un substrat sensible à l'oxydation, une pluralité de couches atomiques superposées. Les couches atomiques, également appelées monocouches, sont identiques et elles constituent une couche mince d'une épaisseur prédéterminée. Elles comportent au moins un métal et un élément chimique non métallique tel que l'oxygène. Le métal est, par exemple, choisi parmi l'hafnium, le zirconium, le titane, l'yttrium, le praséodyme et le lanthane. La couche mince est, de préférence, constituée par un oxyde métallique ayant une constante diélectrique élevée, par exemple en HfO₂, en ZrO₂ ou en TiO₂.

Les couches atomiques sont formées par répétition d'un cycle de réaction selon l'art antérieur tel que représenté à la figure 1. A titre d'exemple, les figures 2 à 5 illustrent le principe des différentes étapes du cycle de réaction permettant théoriquement d'obtenir le dépôt d'une couche atomique en HfO₂ sur un substrat 1 en silicium. Pour réaliser le dépôt, le substrat 1 est disposé dans un réacteur 2 étanche et il comporte à sa surface une couche oxydée 3 en SiO₂ destinée à recevoir la couche atomique en HfO₂ et également appelée couche interfaciale.

Un premier réactif métallique halogéné 4, par exemple HfCl₄ dans le cas d'un dépôt d'une couche atomique en HfO₂, est injecté dans le réacteur 2 (figure 2) pendant une période de 50 à 100 millisecondes. Le métal 5, Hf, se dépose et réagit alors avec la surface de la couche oxydée 3.

Une fois l'étape d'injection d'HfCl₄ terminée, le réacteur est purgé en faisant passer un flux d'azote dans le réacteur, pendant quelques centaines de millisecondes. Ainsi, à la figure 3, l'introduction d'azote dans le réacteur 2 est représentée par la flèche 6 entrant dans le réacteur 2 tandis que l'élimination de l'azote est représentée par la flèche 7 quittant le réacteur 2. Cette étape de purge permet d'éliminer le réactif 4 en excès et les produits de réaction 8 gazeux (figure 2).

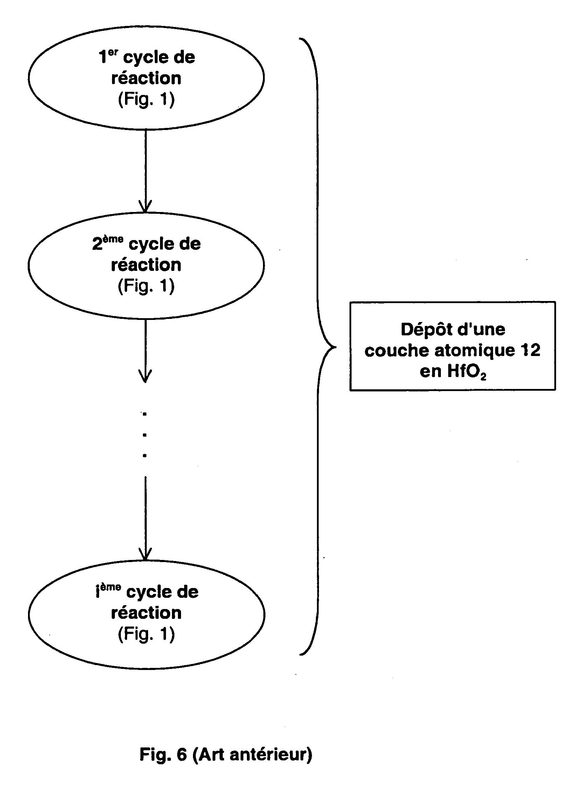

Puis, comme représenté à la figure 4, un second réactif 9, de l'eau dans le cas d'une couche atomique en HfO₂, est injecté dans le réacteur 2 de manière à ce que l'élément non métallique 10, l'oxygène dans le cas de l'eau, réagisse avec le métal 5, Hf, déposé sur le substrat. Cette étape d'injection se déroule pendant une période de 50 à 100 millisecondes. Puis, une seconde étape de purge (figure 5) telle que celle précédant l'étape d'injection du second réactif, est réalisée pour éliminer du réacteur, le second réactif 9 en excès et les produits de réaction 11 gazeux.

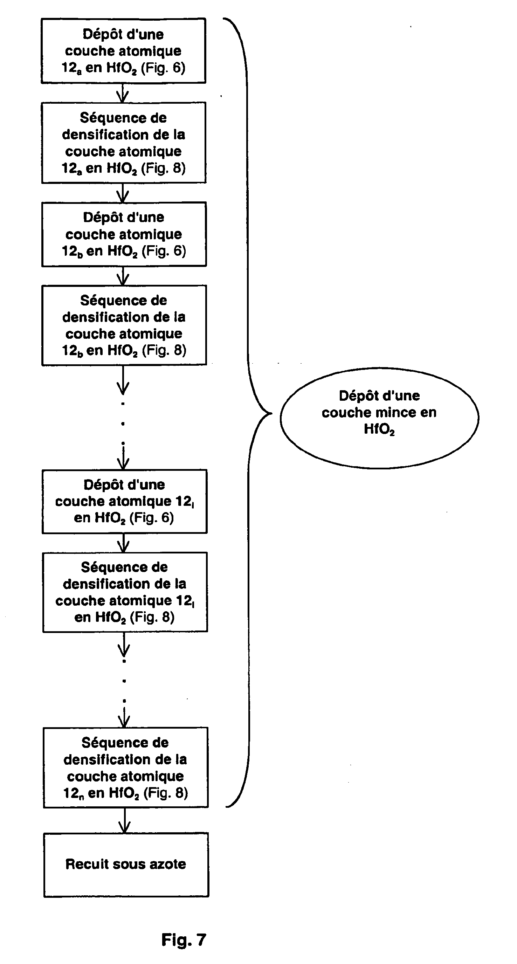

Bien que théoriquement, un cycle de réaction permette de former une couche atomique 12 en HfO₂, comme illustré à la figure 6, il est généralement nécessaire de réaliser successivement plusieurs cycles de réaction pour obtenir une couche atomique 12.

Afin de limiter le phénomène de re-croissance de la couche interfaciale 3, le procédé de dépôt de type "ALD" d'une couche mince comporte, après chaque dépôt d'une couche atomique 12, au moins une séquence de densification de la couche atomique 12 précédemment déposée, la durée d'une séquence de densification étant, de préférence, largement supérieure à la durée d'un cycle de réaction.

Les différentes étapes du dépôt d'une couche mince en HfO₂ sont illustrées à la figure 7. Ainsi, le dépôt d'une couche mince en HfO₂ consiste à déposer une pluralité de couches atomiques en HfO₂, 12ₐ, 12_{b},...,12ᵢ, ...,12ₙ par répétition de cycles de réaction, tel que représenté à la figure 6, et entre deux étapes de dépôt respectivement d'une couche atomique 12ᵢ en HfO₂ et d'une couche atomique 12ᵢ₊₁ en HfO₂, une séquence de densification de la couche atomique 12ᵢ précédemment déposée est réalisée de manière à densifier la couche atomique 12ᵢ. Une fois la couche mince formée, celle-ci peut subir un recuit à haute température, sous azote, de manière à stabiliser la couche mince. La température du recuit est, de préférence, de 800°C.

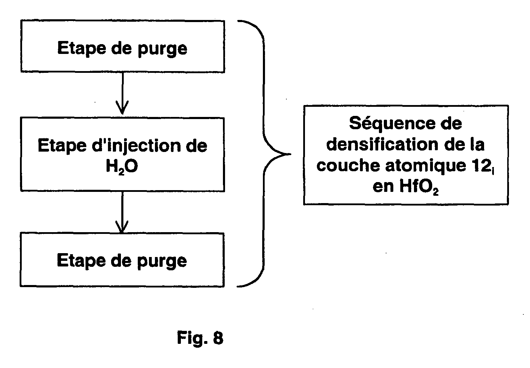

Comme illustré à la figure 8, chaque séquence de densification comporte successivement une étape de purge avec de l'azote, une étape d'injection supplémentaire du second réactif 9, par exemple de l'eau dans le cas d'une couche en HfO₂ et une étape de purge avec de l'azote. La durée de chaque étape de purge de la séquence de densification et la durée de l'étape d'injection supplémentaire sont, de préférence, largement supérieures aux durées respectives de chaque étape de purge et de l'étape d'injection du second réactif des cycles de réaction. Ainsi, la durée de l'étape d'injection supplémentaire peut être comprise entre 300 millisecondes et 1000 millisecondes. La durée des étapes de purge de la séquence est, de préférence, de l'ordre de quelques secondes alors que, lors des cycles de réaction, la durée des étapes de purge est de l'ordre de quelques centaines de millisecondes.

A titre de comparaison, deux couches minces en HfO₂ de 2nm d'épaisseur sont respectivement déposées sur une couche oxydée d'un même substrat en silicium par un procédé de dépôt selon l'invention et par un procédé de dépôt selon l'art antérieur. Par procédé de dépôt selon l'art antérieur, on entend un procédé de dépôt de type "ALD", sans séquence de densification entre chaque dépôt d'une couche atomique, c'est-à-dire un procédé de dépôt de type "ALD" ne comportant que la répétition de cycles de réaction.

Le dépôt de la couche mince selon l'invention comporte ainsi, après chaque dépôt d'une couche atomique, une séquence de densification comprenant :
- une étape de purge sous azote pendant une durée de 4 secondes,
- une étape supplémentaire d'injection d'eau pendant 0,8 secondes,
- et une étape de purge sous azote pendant 4 secondes.

Dans les deux procédés, respectivement selon l'invention et selon l'art antérieur, les durées des différentes étapes des cycles de réaction sont identiques et sont celles utilisées classiquement dans les procédés de type "ALD".

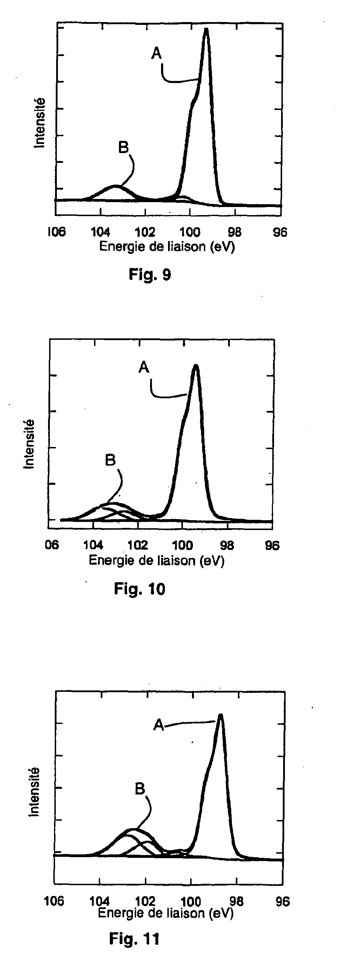

L'épaisseur initiale de la couche oxydée du substrat est déterminée par spectroscopie par photoélectrons par rayons X aussi appelée XPS. Ainsi, le spectre du niveau de coeur Si 2p, obtenu par XPS et représenté à la figure 9, du substrat en silicium comporte deux pics A et B. Le pic A correspond à la contribution du substrat en silicium tandis que le pic B, de plus faible intensité correspond à la contribution de la couche oxydée en SiO₂. L'épaisseur initiale de la couche oxydée, avant dépôt d'une couche mince en HfO₂, est estimée à 0,65nm ± 0,05, en comparant l'intensité des deux pics A et B.

Les spectres de niveau de coeur Si 2p obtenu par XPS des deux couches minces en HfO₂ respectivement déposées selon l'art antérieur et selon l'invention, avant et après recuit sous azote, à 800°C sont représentés aux figures 10 à 13. Ils permettent d'évaluer le phénomène de re-croissance de la couche oxydée après recuit.

Ainsi, les spectres représentés aux figures 10 et 11, correspondant à la couche mince déposée selon l'art antérieur, indiquent, après quantification, que l'épaisseur de la couche oxydée interfaciale est de 0,7 nm ± 0,05 après dépôt et de 1 à 1,2 nm ± 0,05 après recuit.

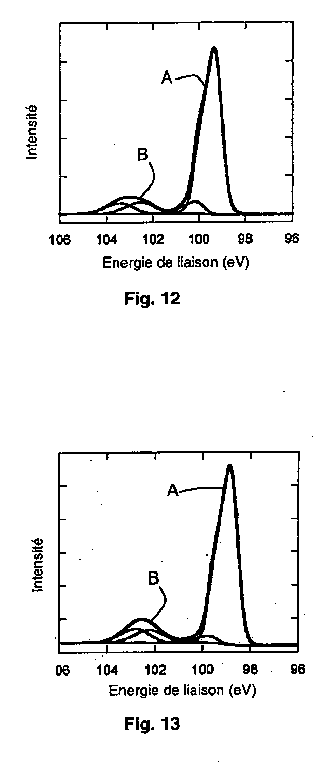

Les spectres représentés aux figures 12 et 13, correspondant à la couche mince déposée selon l'invention indiquent, après quantification, que l'épaisseur de la couche oxydée interfaciale reste constante, même après le recuit sous azote.

En effet, elle est estimée à 0,6 nm ± 0,05 après dépôt (figure 12) et après recuit (figure 13).

On observe donc, après recuit, un phénomène de re-croissance de la couche interfaciale oxydée, lorsque la couche mince en HfO₂ est déposée selon le procédé de dépôt selon l'art antérieur alors qu'avec le procédé de dépôt selon l'invention, l'épaisseur de la couche interfaciale oxydée est contrôlée.

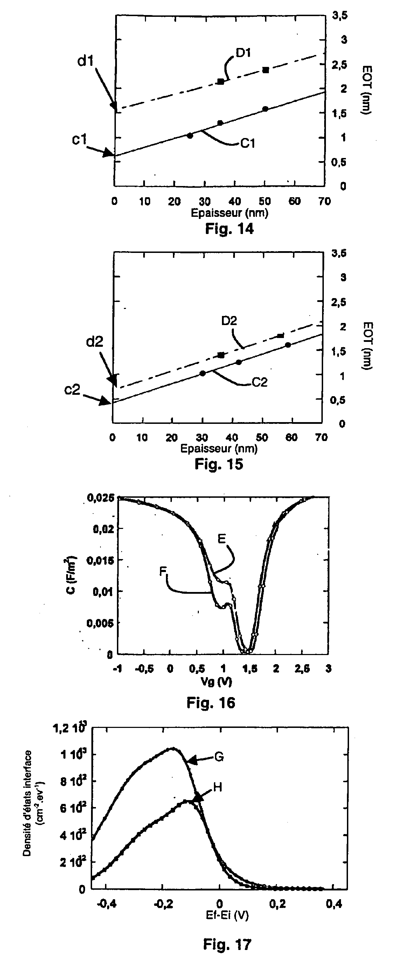

Comme illustré aux figures 14 et 15, le phénomène de re-croissance de la couche interfaciale observée après le recuit d'une couche mince en HfO₂ déposée selon l'art antérieur fait perdre le bénéfice apporté par l'introduction du matériau "High K" et empêche d'atteindre des épaisseurs d'équivalence d'oxyde (EOT) inférieure ou égale à 1nm. En effet, les figures 14 et 15 représentent la variation de la valeur d'EOT, mesurée par goutte de mercure, en fonction de l'épaisseur des couches en HfO₂ déposées respectivement selon l'art antérieur et selon l'invention, avant et après recuit. Ainsi, la figure 14 comporte deux courbes C1 et D1 correspondant à la variation de la valeur d'EOT en fonction de l'épaisseur d'HfO₂ déposé selon l'art antérieur, respectivement avant et après recuit, tandis que la figure 15 comporte deux courbes C2 et D2 correspondant à la variation de la valeur d'EOT en fonction de l'épaisseur d'HfO₂ déposé selon l'invention, respectivement avant et après recuit

On observe qu'avant recuit, les courbes C1 et C2 sont sensiblement identiques alors qu'après recuit, l'écart entre les courbes C1 et D1 est plus important que celui entre les courbes C2 et D2. Ainsi, avant recuit et pour une même épaisseur, les valeurs d'EOT sont sensiblement identiques pour les couches déposées selon l'art antérieur et selon l'invention alors qu'après recuit, les valeurs d'EOT des couches déposées selon l'art antérieur sont plus élevées que celles des couches déposées selon l'invention. De plus, les valeurs d'EOT des couches déposées selon l'invention sont peu sensibles au recuit et la constante diélectrique du HfO₂ extraite de la figure 15 est de l'ordre de 20 avant et après recuit. La réponse électrique des couches en HfO₂ élaborées selon l'invention est donc meilleure que celle des couches élaborées selon l'art antérieur.

De plus, l'ordonnée à l'origine des courbes C1, D1, C2 et D2 correspond à la valeur d'EOT de la couche interfaciale, avant et après recuit, et pour un procédé de dépôt selon l'art antérieur et selon l'invention. Le procédé de dépôt selon l'invention permet d'obtenir, après recuit, une valeur d'EOT pour la couche interfaciale plus faible que le procédé de dépôt selon l'art antérieur. En effet, avant recuit, la valeur de l'EOT de la couche interfaciale dans les deux procédés de dépôt est de 0,5nm (Points c1 et c2 des courbes C1 et C2) bien que le dépôt ait été effectué sur une couche de 0,7nm d'oxyde de silicium. Après recuit, la valeur de l'EOT est de 0,67nm dans le cas du procédé de dépôt selon l'invention (point d2 de la courbe D2) alors qu'elle atteint la valeur de 1,55 nm dans le cas du procédé dépôt selon l'art antérieur (point d1 de la courbe D1).

De plus, d'autres paramètres électriques tels que la densité d'états d'interface sont améliorés dans le cas d'un dépôt selon l'invention par rapport à un dépôt selon l'invention, comme illustré aux figures 16 et 17.

La figure 16 comporte deux courbes électriques E et F représentant respectivement la variation de la capacité en fonction de la tension d'un composant de type capacitif élaboré sur un substrat comportant une couche en HfO₂ déposée selon l'art antérieur et selon l'invention et ayant la même valeur d'EOT égale à 0,10nm. Ainsi, pour des valeurs d'EOT équivalentes, la densité d'état d'interface extraite de la courbe F est plus faible que pour la courbe E. Ceci montre, alors, qu'une couche d'HfO₂ déposée selon l'invention conduit à une interface avec le substrat contenant moins de pièges électriques qu'une couche d'HfO₂ déposée selon l'art antérieur et donc à une interface de meilleure qualité. Ce résultat est également visible à la figure 17 qui comporte deux courbes G et H représentant chacune la variation de la densité des états de surface en fonction de la valeur Ef-Ei. Ef et Ei correspondent respectivement à l'énergie du niveau de Fermi Ef et à l'énergie du niveau de l'état i Ei variant entre la bande de valence et la bande de conduction. Les valeurs des courbes G et H sont respectivement extraites des figures E et F.

L'invention n'est pas limitée aux modes de réalisation décrits ci-dessus. A titre d'exemple, le substrat peut être constitué par tout type de matériau sensible à l'oxydation, il peut par exemple être en germanium ou en silicium-germanium (SiGe). Par ailleurs, plusieurs séquences de densification successives peuvent être réalisées après chaque dépôt de couche atomique.

## Revendications

1. Procédé de dépôt par couche atomique d'une couche mince comprenant au moins un métal (5) et un élément chimique non métallique (10) sur une couche oxydée (3) d'un substrat (1) disposé dans un réacteur (2), la couche mince étant constituée par une pluralité de couches atomiques (12) superposées, formées par répétition d'un cycle de réaction comprenant au moins les étapes successives suivantes :
- une première étape d'injection dans le réacteur (1) d'un premier réactif métallique halogéné (4),
- une première étape de purge du réacteur,
- une seconde étape d'injection dans le réacteur d'un second réactif (9) comportant l'élément chimique non métallique (10),
- une seconde étape de purge du réacteur,
procédé de dépôt **caractérisé en ce qu'**il comporte, après chaque dépôt d'une couche atomique (12), au moins une séquence de densification comportant une troisième étape de purge, une étape d'injection supplémentaire du second réactif (10) et une quatrième étape de purge.

2. Procédé selon la revendication 1, **caractérisé en ce que** la durée d'une séquence de densification est largement supérieure à la durée d'un cycle de réaction.

3. Procédé selon l'une des revendications 1 et 2, **caractérisé en ce que** les durées de chaque étape de purge et de l'étape d'injection supplémentaire d'une séquence sont largement supérieures aux durées respectives de chaque étape de purge et de la second étape d'injection d'un cycle de réaction.

4. Procédé selon la revendication 3, **caractérisé en ce que** la durée de l'étape d'injection supplémentaire est comprise entre 300 millisecondes et 1000 millisecondes tandis que la durée de la seconde étape d'injection est comprise entre 50 millisecondes et 100 millisecondes.

5. Procédé selon l'une des revendications 3 et 4, **caractérisé en ce que** la durée des troisième et quatrième étapes de purge est de quelques secondes tandis que la durée des première et seconde étapes de purge est de quelques centaines de millisecondes.

6. Procédé selon l'une quelconque des revendications 1 à 5, **caractérisé en ce que** l'élément chimique non métallique (10) de la couche mince est l'oxygène.

7. Procédé selon la revendication 6, **caractérisé en ce que** le second réactif (9) est de l'eau.

8. Procédé selon l'une quelconque des revendications 1 à 7, **caractérisé en ce que** le métal (5) de la couche mince est choisi parmi l'hafnium, le zirconium, le titane, l'yttrium, le praséodyme et le lanthane.

9. Procédé selon l'une quelconque des revendications 1 à 8, **caractérisé en ce qu'**une fois la couche mince formée, elle subit un recuit à une température de 800°C, sous azote.

10. Procédé selon l'une quelconque des revendications 1 à 9, **caractérisé en ce que** le substrat (1) est constitué par un matériau choisi parmi le silicium, le germanium et le silicium-germanium.

## Claims

1. Process for atomic layer deposition of a thin layer comprising at least a metal (5) and a non-metallic chemical element (10) on an oxidized layer (3) of a substrate (1) arranged in a reactor (2), the thin layer being formed by a plurality of superposed atomic layers (12), formed by repetition of a reaction cycle comprising at least the following successive steps:
- a first step of injecting a first halogenated metallic reagent (4) into the reactor (1),
- a first reactor purging step,
- a second step of injecting a second reagent (9) comprising the non-metallic chemical element (10) into the reactor,
- a second reactor purging step,
deposition process **characterized in that** it comprises, after each deposition of an atomic layer (12), at least one densification sequence comprising a third purging step, an additional injection step of the second reagent (10) and a fourth purging step.

2. Process according to claim 1, **characterized in that** the time length of a densification sequence is substantially longer than the time length of a reaction cycle.

3. Process according to one of the claims 1 and 2, **characterized in that** the time lengths of each purging step and of the additional injection step of a sequence are substantially longer than the respective time lengths of each purging step and of the second injection step of a reaction cycle.

4. Process according to claim 3, **characterized in that** the time length of the additional injection step is comprised between 300 milliseconds and 1000 milliseconds whereas the time length of the second injection step is comprised between 50 milliseconds and 100 milliseconds.

5. Process according to one of the claims 3 and 4, **characterized in that** the time length of the third and fourth purging steps is a few seconds whereas the time length of the first and second purging steps is a few hundred milliseconds.

6. Process according to any one of the claims 1 to 5, **characterized in that** the non-metallic chemical element (10) of the thin layer is oxygen.

7. Process according to claim 6, **characterized in that** the second reagent (9) is water.

8. Process according to any one of the claims 1 to 7, **characterized in that** the metal (5) of the thin layer is selected among hafnium, zirconium, titanium, yttrium, praseodymium and lanthanum.

9. Process according to any one of the claims 1 to 8, **characterized in that**, after formation of the thin layer, it is subjected to an annealing step, at a temperature of 800°C, in a nitrogen atmosphere.

10. Process according to any one of the claims 1 to 9, **characterized in that** the substrate (1) is formed by a material selected among silicon, germanium and silicon-germanium.

## Patentansprüche

1. Verfahren zum Atomschicht-Abscheiden einer dünnen Schicht, die mindestens ein Metall (5) und ein nichtmetallisches chemisches Element (10) umfasst, auf einer oxidierten Schicht (3) eines Substrats (1), das in einem Reaktor (2) angeordnet ist, wobei die dünne Schicht von mehreren übereinander angeordneten Atomschichten (12) gebildet wird, die durch Wiederholung eines Reaktionszyklus hergestellt werden, der mindestens folgende aufeinanderfolgende Schritte umfasst:
- einen ersten Einlass-Schritt für den Einlass eines ersten metallischen, halogenierten Reaktionsmittels (4) in den Reaktor (1),
- einen ersten Entleerungsschritt für die Entleerung des Reaktors,
- einen zweiten Einlass-Schritt für den Einlass eines zweiten Reaktionsmittels (9), das das nichtmetallische Element umfasst, in den Reaktor,
- einen zweiten Entleerungsschritt für die Entleerung des Reaktors,
Abscheidungsverfahren, das **dadurch gekennzeichnet ist, dass** es nach jeder Abscheidung einer Atomschicht (12) mindestens eine Verdichtungssequenz umfasst, die einen dritten Entleerungsschritt, einen zusätzlichen Einlass-Schritt für den Einlass des zweiten Reaktionsmittels (10) und einen vierten Entleerungsschritt umfasst.

2. Verfahren nach Anspruch 1, **dadurch gekennzeichnet, dass** die Dauer eines Verdichtungszyklus die Dauer eines Reaktionszyklus bei weitem übersteigt.

3. Verfahren nach einem der Ansprüche 1 und 2, **dadurch gekennzeichnet, dass** die Dauer jedes Entleerungsschritts und des zusätzlichen Einlass-Schritts einer Sequenz die entsprechende Dauer der einzelnen Entleerungsschritte und des zweiten Einlass-Schritts eines Reaktionszyklus bei weitem übersteigt.

4. Verfahren nach Anspruch 3, **dadurch gekennzeichnet, dass** die Dauer des zusätzlichen Einlass-Schritts 300 bis 1000 Millisekunden beträgt, während die Dauer des zweiten Einlass-Schritts 50 bis 100 Millisekunden beträgt.

5. Verfahren nach einem der Ansprüche 3 und 4, **dadurch gekennzeichnet, dass** die Dauer des dritten und vierten Entleerungsschritts einige Sekunden beträgt, während die Dauer des ersten und zweiten Entleerungsschritts einige Hundert Millisekunden beträgt.

6. Verfahren nach einem der Ansprüche 1 bis 5, **dadurch gekennzeichnet, dass** das nichtmetallische chemische Element (10) der dünnen Schicht Sauerstoff ist.

7. Verfahren nach Anspruch 6, **dadurch gekennzeichnet, dass** das zweite Reaktionsmittel (9) Wasser ist.

8. Verfahren nach einem der Ansprüche 1 bis 7, **dadurch gekennzeichnet, dass** das Metall (5) der dünnen Schicht aus der von Hafnium, Zirkon, Titan, Yttrium, Praseodym und Lanthan gebildeten Gruppe ausgewählt ist.

9. Verfahren nach einem der Ansprüche 1 bis 8, **dadurch gekennzeichnet, dass** die dünne Schicht nach ihrem Aufbringen einem Glühen bei einer Temperatur von 800°C unter Stickstoff unterzogen wird.

10. Verfahren nach einem der Ansprüche 1 bis 9, **dadurch gekennzeichnet, dass** das Substrat (1) aus einem Material besteht, das aus der aus Silizium, Germanium und Silizium-Germanium gebildeten Gruppe ausgewählt ist.
